# EUROPÄISCHE PATENTSCHRIFT

(11) **EP 1 108 203 B1**
(45) Veröffentlichungstag und Bekanntmachung des Hinweises auf die Patenterteilung: **16.03.2005**
(21) Anmeldenummer: 99953629.5
(22) Anmeldetag: 27.08.1999
(51) Int. Cl.: G01L 9/00, G01L 9/12, G01P 15/08, H04R 7/10

(54) **VOR UMWELTEINFLÜSSEN GESCHÜTZTES MIKROMECHANISCHES BAUELEMENT**
MICROMECHANICAL COMPONENT PROTECTED AGAINST ENVIRONMENTAL INFLUENCES
COMPOSANT MICROMECANIQUE PROTEGE CONTRE LES INFLUENCES DE L'ENVIRONNEMENT

(30) Priorität: 27.08.1998 DE 19839122
(43) Veröffentlichungstag der Anmeldung: 20.06.2001
(73) Patentinhaber: Infineon Technologies AG, 81669 München (DE)
(72) Erfinder: AIGNER, Robert, D-81675 München (DE); HIEROLD, Christofer, D-81739 München (DE); KAPELS, Hergen, D-85579 Neubiberg (DE); KOLB, Stefan, D-85716 Unterschlei heim (DE); MAIER-SCHNEIDER, Dieter, D-85570 Markt Schwaben (DE); OPPERMANN, Klaus-Günter, D-83607 Holzkirchen (DE); TIMME, Hans-Jörg, D-85521 Ottobrunn (DE); SCHEITER, Thomas, D-82041 Oberhaching (DE); WERNER, Wolfgang, D-81545 München (DE)
(74) Vertreter: Zimmermann & Partner
(86) Internationale Anmeldenummer: PCT/DE1999/002698
(87) Internationale Veröffentlichungsnummer: WO 2000/012987

(56) Entgegenhaltungen:
- EP-A- 0 624 900
- EP-A- 0 822 398
- US-A- 5 335 550

## Beschreibung

Die Erfindung betrifft ein mikromechanisches Bauelement, vorzugsweise einen mikromechanischen Sensor umfassend einen Wafer, eine Membran, einen Hohlraum, eine oder mehrere als Auflage für die Membran dienende Opferschichten, Hilfsschichten, gegebenenfalls eine in das Bauelement integrierte Elektronik und mindestens eine Öffnung, welche eine Verbindung der Membran zur Umgebung des Bauelements herstellt.

Mikromechanische Bauelemente sind in einer Reihe von Dokumenten beschrieben. Dokument US-A-5,335,550 offenbart beispielsweise einen Drucksensor, der sich aus zwei Halbleitersubstraten zusammensetzt. Dabei ist in einem der Halbleitersubstrate eine Vertiefung vorgesehen, die später als Hohlraum bzw. Vakuumkammer für den Drucksensor dient. Weiterhin sind auf der Oberfläche des zweiten Halbleitersubstrats durch Diffusion erzeugte Widerstände und eine entsprechende verdrahtung vorgesehen. Die beiden Halbleitersubstrate sind über einen isolierenden Film miteinander verbunden, so daß unterhalb der durch Diffusion erzeugten Widerstände auf der Rückseite des zweiten Halbleitersubstrats der Hohlraum entsteht.

Anstatt den Höhlraum durch das Zusammenfügen zweier Halbleitersubstrate zu erzeugen, kann der Hohlraum auch durch eine isotrope Ätzung hergestellt werden. Dokument BP-A 0 624 900 offenbart beispielsweise ein derartiges Verfahren zur Herstellung von integrierten Sensoren. Dazu werden ausgehend von einer Substratoberfläche Gräben in dem Substrat erzeugt, die anschließend zur Erzeugung des eigentlichen Hohlraums genutzt werden.

Mikromechanische Bauelemente, beispielsweise zur Verwendung als Mikrofonsensoren, Drucksensoren oder Beschleunigungssensoren, sind beispielsweise aus der EP-A 0 714 017 bekannt. Die beschriebenen mikromechanischen Bauelemente weisen einen Hohlraum auf, der auf einer Seite von einer beispielsweise aus Metall oder Polysilizium gebildeten Membranschicht begrenzt ist. Die Membranschicht ist in einem Bereich elektrisch leitfähig gemacht und bildet gemeinsam mit einer auf der gegenüberliegenden Seite des Hohlraums angeordneten Gegenelektrode eine elektrische Kapazität, welche zur Messung von zeitlichen Volumenänderungen des Hohlraums herangezogen wird. Gemäß einem Ausführungsbeispiel können oberhalb der Membranfläche weitere Schichten angeordnet sein, die eine Versteifung der Membran bewirken. In diese zusätzlichen Schichten sind zur Verbesserung der Beweglichkeit der Membran oberseitig zur Membranfläche hinabreichende Öffnungen hineingeätzt. Diese Öffnungen können von beliebiger Form, z.B. rund oder eckig sein. Es ist auch möglich, daß die Öffnungen Kanäle sind, die ringförmig geschlossen sind, z.B in Form eines vierecks oder eines Kreises.

Die gegebenenfalls große Zahl von oberhalb der Membranschicht angeordneten Schichten und insbesondere die aufgrund der Schichten mit der Umwelt in Kontakt stehenden Grenzflächen in einem mikromechanischen Bauelement des vorstehend genannten Typs erfordern zusätzliche Maßnahmen zum Schutz gegen äußere Umwelteinflüsse, wie Luftfeuchtigkeit usw., die eine Beeinträchtigung der Funktion des mikromechanischen Beuelements zur Folge haben können. Steht das Bauelement beispielsweise während einer Druckmessung mit einem aggressiven Medium in Kontakt, so werden die empfindlichen Schichten überwiegend im Bereich der Kontaktstellen unterschiedlicher Schichten chemisch oder physikalisch angegriffen. Zum Schutz der mikromechanischen Bauelemente gegenüber äußeren Einflüssen bzw. zum Schutz eines Drucksensors vor einem am Sensor anliegenden Druckmedium wurden die Bauelemente bisher nach der Vereinzelung zu Chips gekapselt oder in sonstiger Weise eingehüllt, beispielsweise mit einem Gummi oder durch Beschichtung des Bauelements mit einem Gel in einem geeigneten Gehäuse.

Ausgehend von diesen Problemen ist eine Aufgabe der vorliegenden Erfindung die Bereitstellung eines Verfahren zur Herstellung eines mikromechanischen Bauelements, vorzugsweise eines mikromechanischen Sensors in herkömmlicher HalbleiterTechnologie, welches einen vor Umwelteinflüssen geschütztes mikromechanisches Bauelement vorzugsweise einen Sensor zur Verfügung stellt und ohne zusätzliche Maßnahmen zum Schutz des Bauelements nach der Vereinzelung des Wafers zu Chips auskommt.

Eine weitere Aufgabe der Erfindung ist die Bereitstellung eines mikromechanischen Bauelements, vorzugsweise eines mikromechischen Sensors, welches nicht nachträglich, beispielsweise nach der Vereinzelung zu Chips extern geschützt oder verkapselt werden muß.

Diese Aufgabe wird erfindungsgemäß gelöst durch ein Verfahren zur Herstellung eines mikromechanischen Bauelements, vorzugsweise eines mikromechanischen Sensors umfassend die Herstellung eines mikromechanischen Bauelements aus einem Wafer 1, einer Membran 2, einem Hohlraum 3, einer oder mehreren als Auflage für die Membran dienenden Opferschichten 4, welche auf dem Wafer angeordnet sind, Hilfsschichten 7 zur Planarisierung der Bauelementoberfläche und/oder zur Aufnahme von Leiterbahnen oder Halbleiterbauelementen, mindestens einer Öffnung 6, welche eine Verbindung der Umgebung des Bauelements zur Membran herstellt und ggf. einer oder mehreren Schaltungsschutzschichten auf den Hilfsschichten 7, welches dadurch gekennzeichnet ist, daß vor der Vereinzelung des Wafers zu Chips auf das Bauelement mindestens eine Bauelementschutzschicht 9 und/oder Abstandsbeschichtung 10 aufgebracht wird, wobei die Bauelementschutzschicht zumindest die im wesentlichen parallel zur Waferoberfläche verlaufenden und die im wesentlichen senkrecht zur Waferoberfläche verlaufenden Wandungen der Öffnungen abdichtend bedeckt und die Abstandsbeschichtung zumindest die im wesentlichen senkrecht zur Waferoberfläche verlaufenden Wandungen der Öffnungen abdichtend bedeckt.

Die Erfindung betrifft auch einen nach dem Verfahren der Erfindung herstellbaren mikromechanisches Bauelement umfassend einen Wafer 1, einen oberhalb des Wafers liegenden Hohlraum 3 mit einer darüberliegenden Membran 2, mindestens eine als Auflagefläche für die Membran dienende Opferschicht 4, oberhalb der Membran und des Wafers angeordnete Hilfsschichten 7 zur Planarisierung der Bauelementoberfläche und/oder zur Herstellung von Elementen für eine Halbleiterelektronik, mindestens eine die Membranfläche mit der oberseitigen Umgebung verbindende Öffnung 6 und gegebenenfalls eine oder mehrere Schaltungsschutzschichten oberhalb der Hilfsschichten 7, welcher dadurch gekennzeichnet ist, daß die Kontur der Öffnungen 6 mit mindestens einer Bauelementschutzschicht 9 und/oder mindestens einer Abstandsbeschichtung 10 abdichtend bedeckt ist.

Ferner betrifft die Erfindung die Verwendung des nach dem Verfahren der vorliegenden Erfindung herstellbaren mikromechanischen Bauelements für Sensoren, vorzugsweise Mikrofone, Drucksensoren oder Beschleunigungssensoren, insbesondere für Drucksensoren in Airbags.

Vorteilhafte Ausführungsformen ergeben sich aus den Unteransprüchen.

Es folgt eine Beschreibung der Herstellung eines erfindungsgemäßen Drucksensors anhand der Ausführungsbeispiele in den Figuren 2 bis 4.
- Figur 1: zeigt eine an sich bekannte Ausgestaltung für einen Drucksensor im Querschnitt.
- Figur 2: zeigt einen erfindungsgemäßen Drucksensor im Querschnitt mit einer Bauelementschutzschicht 9.
- Figur 3: zeigt eine alternative Ausgestaltung für einen Drucksensor gemäß der Erfindung mit einer Abstandsbeschichtung 10.
- Figur 4: zeigt eine Ausgestaltung gemäß der Erfindung mit Bauelementschutzschicht 9 und Abstandsbeschichtung 10.

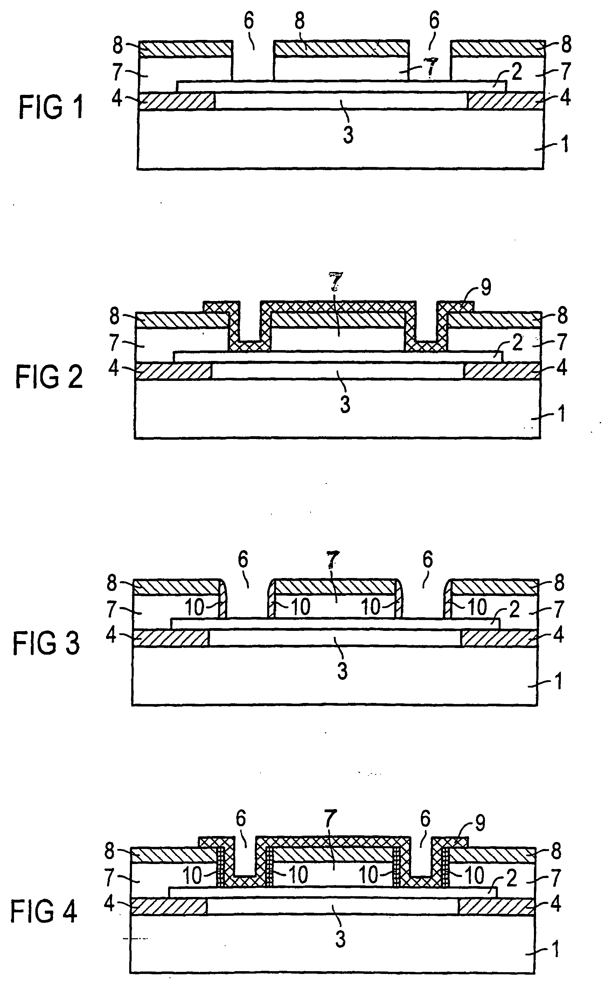

Der in Figur 1 dargestellte Drucksensor gemäß dem Stand der Technik besteht aus einem Siliziumwafer 1 und einer darüber befindlichen Membranschicht aus Polysilizium. Zwischen Wafer 1 und Membran 2 befindet sich ein Hohlraum 3. Die Membran wird durch außen angelegte Drücke oder Druckschwankungen zu Auslenkungen oder Schwingungen angeregt. Zwischen Wafer und Membranschicht befinden sich zusätzliche Schichten 4, die in der Regel elektrisch isolierend ausgebildet sind. Auf diesen Schichten liegt die Membran seitlich auf. Oberhalb der Membran sind Hilfsschichten 7 angeordnet, die beispielsweise Verschlußschichten oder Planarisierungsschichten sein können. Während der Herstellung des Sensors läßt sich eine ebenfalls auf dem Chip des Sensors angeordnete Halbleiterschaltung in Maskentechnologie herstellen. Die Membranfläche des Sensors wird dann beispielsweise gemeinsam mit Gateelektroden von MOSFET's hergestellt. Zum Schutz der Hilfsschichten 7 bzw. der zusätzlichen Halbleiterschaltungselemente vor äußeren Einflüssen befindet sich oberhalb der Anordnung eine Schaltungsschutzschicht 8 aus einem geeigneten Material, vorzugsweise aus einem Oxid oder Nitrid, wie etwa SiO₂ oder Si₃N₄. Im letzten Schritt wird durch Ätzung eine kragenförmige Öffnung 6 in den mikromechanischen Sensor geätzt, wobei der Ätzprozess an der Sensoroberfläche abgestoppt wird. Hierdurch entsteht eine auf der Membran stehen bleibende Reststruktur, welche die mechanischen Eigenschaften des Sensors in großem Maße bestimmt. Vorzugsweise werden die Öffnungen 6 mit einem Trockenätzverfahren hergestellt.

Figur 2 zeigt einen erfindungsgemäßen Drucksensor mit einer Bauelementschutzschicht 9. Die Bauelementschutzschicht 9 wird zum Schutz der empfindlichen Flanken, insbesondere der Schichtübergänge, und der Chipflächen, welche die Eigenschaften des Bauelements bestimmen, im Bereich der Öffnung 6 aufgebracht. Die Schicht 9 umschmiegt die topologische Oberflächenstruktur des Sensors so, daß eine vollkommene Abdichtung gegenüber äußeren Einflüssen bewirkt wird. Die Bauelementschutzschicht 9 kann vorzugsweise durch Aufbringen von Plasmanitrid, Titan oder Titannitrid hergestellt werden. Durch diese besonders hochwertige Bedeckung wird ein wirksamer Schutz der empfindlichen Schichtstruktur im Bereich der Öffnung 6 erhalten. Ein zusätzlicher Schutz des Sensors durch ein externes Gehäuse kann im Prinzip entfallen. Bei der Herstellung des Drucksensors gemäß Figur 2 wurde mit einer zusätzlichen Maske ein Bereich definiert, in dem die Bauelementschutzschicht 9 räumlich begrenzt auf der Oberfläche des mikromechanischen Sensors zu liegen kommt. Es ist auch möglich, daß zunächst ganzflächig eine Bauelementschutzschicht 9 aufgebracht wird und in einem weiteren Schritt im Bereich der von den Öffnungen 6 benachbarten Gebiete die Bauelementschutzschicht 9 durch lokales Ätzen wieder entfernt wird.

Der mikromechanische Sensor gemäß Figur 3 weist eine Abstandsbeschichtungen 10 auf, die an den Flanken der Öffnungen 6 aufgebracht ist. Die Abstandsbeschichtungen 10 bedecken die auf der Membranfläche liegenden Schichten nur seitlich. Die Abstandsbeschichtungen lassen sich durch Abscheidung einer Schutzschicht, beispielsweise aus einer oder mehreren Schichten enthaltend Oxide, Titan, Titannitrid oder Nitrid herstellen. Bevorzugt wird als Abstandsbeschichtung eine Schicht aus einem dünnen Nitrid verwendet. Zunächst wird ganzflächig oder in Teilbereichen eine Schicht auf der Struktur abgeschieden, die zumindest die Öffnungen 6 überragt. Dann wird eine anisotrope Ätzung, beispielsweise ohne zusätzliche Verwendung einer Maske, durchgeführt, welche nur die Kanten der ursprünglichen Schicht stehen läßt. Alle parallel zur Waferfläche verlaufenden Schichtteile werden hierdurch entfernt. Die verbleibenden, im wesentlichen senkrecht zur Waferebene verlaufenden Reste der Beschichtung bilden die Abstandsbeschichtung 10.

Die bevorzugte Ausführungsform in Figur 4 stellt eine Kombination der in Figur 2 und Figur 3 angegebenen Verfahren dar. Zunächst wird gemäß dem in Zusammenhang mit Figur 3 beschriebenen Verfahren eine Abstandsbeschichtung 10 hergestellt. Hierdurch werden Topologieunterschiede oder besonders steile Flanken, wie z. B. Oxidkanten, die eine gleichmäßige Bedekkung verhindern würden, so ausgeglichen, daß im zweiten Schritt das Aufbringen einer Abstandsbeschichtung 10 auf verbesserte Weise erfolgen kann. Die Abstandsbeschichtung führt dann zu einem gegen äußere Einflüsse resistenteren Schutz des Sensors.

Das Verfahren gemäß der vorliegenden Erfindung hat den Vorteil, daß es ohne die Anwendung von Prozeßschritten auskommt, die nicht in einem herkömmlichen Prozeß zur Herstellung von CMOS, BiCMOS oder Bipolar-Halbleiterstrukturen zur Verfügung stehen.

Ein weiterer Vorteil der Erfindung ist, daß bei der Herstellung der Abstandsbeschichtung keine zusätzlichen Masken im Vergleich zum Herstellungsverfahren des Sensors nach Fig. 1 benötigt werden.

Die gemäß den Ausführungsbeispielen 2 bis 4 hergestellten mikromechanischen Sensoren sind unempfindlich gegenüber äußeren Umwelteinflüssen, wie etwa Luftfeuchtigkeit oder Wasser, auf. Eine zusätzliche extern durchzuführende Kapselung, eine Umhüllung, oder ein Schutz der Sensoren mit einem Gel kann bei den erfindungsgemäßen mikromechanischen Sensoren entfallen.

## Patentansprüche

1. Verfahren zur Herstellung eines mikromechanischen Bauelements umfassend die Herstellung eines mikromechanischen Bauelements aus einem Wafer (1), einer Membran (2), einem Hohlraum (3), einer oder mehreren als Auflage für die Membran dienenden Opferschichten (4), welche auf dem Wafer angeordnet sind, Hilfsschichten (7) zur Planarisierung der Bauelementoberfläche und/oder zur Aufnahme von Leiterbahnen oder Halbleiterbauelementen, mindestens einer Öffnung (6), welche eine Verbindung der Umgebung des Bauelements zur Membran herstellt und ggf. einer oder mehreren Schaltungsschutzschichten auf den Hilfsschichten (7),
**dadurch gekennzeichnet, daß** vor der Vereinzelung des Wafers zu Chips auf das Bauelement mindestens eine Bauelementschutzschicht (9) und/oder Abstandsbeschichtung (10) aufgebracht wird, wobei die Bauelementechutzschicht zumindest die im wesentlichen parallel zur Waferoberfläche verlaufenden und die im wesentlichen senkrecht zur Waferoberfläche verlaufenden Wandungen der Öffnungen abdichtend bedeckt und die Abstandsbeschichtung zumindest die im wesentlichen senkrecht zur Waferoberfläche verlaufenden Wandungen der Öffnungen abdichtend bedeckt.

2. Verfahren nach Anspruch 1,
**dadurch gekennzeichnet, daß** die Abstandsbeschichtung (10) hergestellt wird durch die Schritte
- Aufbringen einer oder mehrerer Beschichtungen zumindest in einem parallel zur Waferfläche begrenzten Bereich, wobei der Bereich die Öffnungen (6) überragt und die Beschichtung/-en sich der Kontur der Öffnung weitgehend anpassen,
- anisotrope Ätzung der aufgebrachten Beschichtung in der Weise, daß die Beschichtung/-en auf den parallel zur Waferoberfläche verlaufenden Flächen entfernt wird/werden.

3. verfahren zur Herstellung eines mikromechanischen Bauelements nach Anspruch 2,
**dadurch gekennzeichnet, daß** die Bauelementschutzschicht/-en (9) nach Aufbringen der Abstandsbeschichtung (10) aufgebracht wird/werden, wobei die Bauelementschutzschicht/-en zumindest in einem parallel zur Waferfläche begrenzten, die Öffnungen überragenden Bereich aufgebracht wird/werden und wobei die Bauelementschutzschicht/-en sich der Kontur der Öffnung und der Abstandsbeschichtung weitgehend anpaßt/anpassen.

4. Mikromechanisches Bauelement umfassend einen Wafer (1), einen oberhalb des Wafers liegenden Hohlraum (3) mit einer darüberliegenden Membran (2), mindestens eine als Auflagefläche für die Membran dienende Opferschicht (4), oberhalb der Membran und des Wafers angeordnete Hilfsshichten (7) zur Planarisierung der Bauelementoberfläche und/oder zur Herstellung von Elementen für eine Halbleiterelektronik, mindestens eine die Membranfläche mit der oberseitigen Umgebung verbindende Öffnung (6) und gegebenenfalls eine oder mehrere Schaltungsschutzschichten oberhalb der Hilfsschichten (7),
**dadurch gekennzeichnet, daß** die Kontur der Öffnungen (6) mit mindestens einer Bauelementschutzschicht (9) und/oder mindestens einer Abstandsbeschichtung (10) abdichtend bedeckt ist.

5. Mikromechanisches Bauelement nach Anspruch 4,
**dadurch gekennzeichnet, daß** der Wafer im wesentlichen aus Silizium besteht.

6. Mikromechanisches Bauelement nach Anspruch 4 oder 5,
**dadurch gekennzeichnet, daß** die Membran im wesentlichen aus Polysilizium oder einkristallinem Silizium besteht.

7. Mikromechanisches Bauelement nach einem der Ansprüche 4 bis 6,
**dadurch gekennzeichnet, daß** die Hilfsschichten eine Halbleiterschaltung enthalten, wobei die Halbleiterschaltung zur Auswertung oder Ansteuerung des Bauelements dient.

8. Mikromechanisches Bauelement nach einem der Ansprüche 4 bis 7,
**dadurch gekennzeichnet, daß** die Schaltungsschutzschicht im wesentlichen aus Oxiden und/oder Nitriden besteht.

9. Mikromechanisches Bauelement nach einem der Ansprüche 4 bis 8,
**dadurch gekennzeichnet, daß** die Bauelementschutzschicht mindestens ein Element aus der Gruppe Titan, Titannitrid oder Nitrid enthält.

10. Mikromechanisches Bauelement nach einem der Ansprüche 4 bis 9,
**dadurch gekennzeichnet, daß** die Abstandsbeschichtung (10) im wesentlichen aus einem Nitrid besteht.

11. Verwendung des mikromechanischen Bauelements nach Anspruch 4 für Sensoren.

## Claims

1. Method for producing a micromechanical component comprising the production of a micromechanical component from a wafer (1), a membrane (2), a cavity (3), one or more sacrificial layers (4), which serve as a support for the membrane and are arranged on the wafer, auxiliary layers (7) for planarizing the component surface and/or for receiving conductor tracks or semiconductor devices, at least one opening (6), which establishes a connection between the surroundings of the component and the membrane, and possibly one or more circuit protection layers on the auxiliary layers (7), **characterized in that** at least one component protection layer (9) and/or spacing coating (10) is applied to the component before separating the wafer into individual chips, the component protection layer covering and sealing the walls of the openings running essentially parallel to the surface of the wafer and the walls of the openings running essentially perpendicular to the surface of the wafer, and the spacing coating covering and sealing at least the walls of the openings running essentially perpendicular to the surface of the wafer.

2. Method according to Claim 1, **characterized in that** the spacing coating (10) is produced by the steps of
- applying one or more coatings at least in a limited region parallel to the surface of the wafer, the region rising up above the openings (6) and the coating/s largely adapting it/themselves to the contour of the opening,
- anisotropic etching of the applied coating in such a way that the coating/s is/are removed on the surfaces running parallel to the surface of the wafer.

3. Method for producing a micromechanical component according to Claim 2, **characterized in that** the component protection layer/s (9) is/are applied after applying the spacing layer (10), the component protection layer/s being applied in a limited region parallel to the surface of the wafer and rising up above the openings, and the component protection layer/s largely adapting it/themselves to the contour of the opening and of the spacing coating.

4. Micromechanical component comprising a wafer (1), a cavity (3) lying above the wafer with a membrane (2) lying over it, at least one sacrificial layer (4) serving as a supporting surface for the membrane, auxiliary layers (7) arranged above the membrane and the wafer for planarizing the component surface and/or for producing elements for semiconductor electronics, at least one opening (6) connecting the membrane surface to the surroundings on the upper side and possibly one or more circuit protection layers above the auxiliary layers (7), **characterized in that** the contour of the openings (6) is covered and sealed by at least one component protection layer (9) and/or at least one spacing coating (10).

5. Micromechanical component according to Claim 4, **characterized in that** the wafer consists essentially of silicon.

6. Micromechanical component according to Claim 4 or 5, **characterized in that** the membrane consists essentially of polysilicon or monocrystalline silicon.

7. Micromechanical component according to one of Claims 4 to 6, **characterized in that** the auxiliary layers contain a semiconductor circuit, the semiconductor circuit serving for the evaluation or driving of the component.

8. Micromechanical component according to one of Claims 4 to 7, **characterized in that** the circuit protection layer consists essentially of oxides and/or nitrides.

9. Micromechanical component according to one of Claims 4 to 8, **characterized in that** the component protection layer contains at least one element from the group comprising titanium, titanium nitride or nitride.

10. Micromechanical component according to one of Claims 4 to 9, **characterized in that** the spacing coating (10) consists essentially of a nitride.

11. Use of the micromechanical component according to Claim 4 for sensors.

## Revendications

1. Procédé de fabrication d'un composant micromécanique comprenant la fabrication d'un composant micromécanique à partir d'une tranche (1), d'une membrane (2), d'une cavité (3), d'une ou de plusieurs couches (4) sacrificielles servant de support à la membrane et disposées sur la tranche, de couches (7) auxiliaires de planarisation de la surface du composant et/ou de réception de pistes conductrices ou de composants à semi-conducteur, d'au moins une ouverture (6) qui ménage une communication de ce qui entoure le composant à la membrane, et le cas échéant d'une ou de plusieurs couches de protection de circuit sur les couches (7) auxiliaires,
**caractérisé en ce qu'**avant l'individualisation de la tranche en des puces, on dépose sur le composant au moins une couche (9) de protection du composant et/ou un revêtement (10) de mise à distance, la couche de protection du composant recouvrant de manière étanche au moins les parois des ouvertures s'étendant sensiblement parallèlement à la surface de la tranche et celles s'étendant sensiblement perpendiculairement à la surface de la tranche, et la couche de mise à distance recouvrant de manière étanche au moins les parois des ouvertures s'étendant sensiblement perpendiculairement à la surface de la tranche.

2. Procédé suivant la revendication 1,
**caractérisé en ce que** l'on produit le revêtement (10) de mise à distance par les stades
- de dépôt d'un ou de plusieurs revêtements au moins dans une zone délimitée parallèlement à la surface de la tranche, la zone dépassant des ouvertures (6) et le ou les revêtements étant dans une grande mesure adaptée au contour de l'ouverture,
- d'attaque anisotrope du revêtement déposé, de façon à ce que le ou les revêtements soient éliminés sur les surfaces s'étendant parallèlement à la surface de la tranche.

3. Procédé de fabrication d'un composant micromécanique suivant la revendication 2,
**caractérisé en ce que** l'on dépose la ou les couches (9) de protection du composant après le dépôt du revêtement (10) de mise à distance, la ou les couches de protection du composant étant déposées dans une zone délimitée parallèlement à la surface de la tranche et dépassant des ouvertures, et la ou les couches de protection du composant étant adaptées dans une grande mesure au contour de l'ouverture et du revêtement de mise à distance.

4. Composant micromécanique comprenant une tranche (1), une cavité (3) se trouvant au-dessus de la tranche et ayant au-dessus d'elle une membrane (2), au moins une couche (4) sacrificielle servant de surface de support pour la membrane, des couches (7) auxiliaires disposées au-dessus de la membrane et de la tranche de planarisation de la surface du composant et/ou de production d'éléments pour une électronique à semi-conducteur, au moins une ouverture (6) mettant la surface de la membrane en communication avec ce qui est autour du côté supérieur, et le cas échéant une ou plusieurs couches de protection de circuit au-dessus des couches (7) auxiliaires;
**caractérisé en ce que** le contour de l'ouverture (6) est recouvert d'une manière étanche par au moins une couche (9) de protection du composant et/ou par au moins un revêtement (10) de mise à distance.

5. Composant micromécanique suivant la revendication 4, **caractérisé en ce que** la tranche est essentiellement en silicium.

6. Composant micromécanique suivant la revendication 4 ou 5, **caractérisé en ce que** la membrane est essentiellement en polysilicium ou en silicium monocristallin.

7. Composant micromécanique suivant l'une des revendications 4 à 6, **caractérisé en ce que** les couches auxiliaires contiennent un circuit à semi-conducteur, le circuit à semi-conducteur servant à l'exploitation ou à la commande du composant.

8. Composant micromécanique suivant l'une des revendications 4 à 7, **caractérisé en ce que** la couche de protection de circuit est essentiellement en oxyde et/ou en nitrure.

9. Composant micromécanique suivant l'une des revendications 4 à 8, **caractérisé en ce que** la couche de protection du composant contient au moins un élément choisi dans le groupe constitué du titane, du nitrure de titane ou d'un nitrure.

10. Composant micromécanique suivant l'une des revendications 4 à 9, **caractérisé en ce que** le revêtement (10) de mise à distance est essentiellement en un nitrure.

11. Utilisation du composant micromécanique suivant la revendication 4 pour des capteurs.
